# EUROPEAN PATENT APPLICATION

(11) **EP 4 414 319 A1**
(43) Date of publication of application: **14.08.2024**
(21) Application number: 23167729.5
(22) Date of filing: 13.04.2023
(51) Int. Cl.: B82Y 20/00, B82Y 40/00, G02B 1/00, H01Q 15/00, G03F 7/00

(54) **METASURFACE STRUCTURE AND FABRICATION METHOD THEREOF**

(30) Priority: 08.02.2023 CN 202310101180
(71) Applicant: United Microelectronics Corp., Hsin-Chu City 300 (TW)
(72) Inventor: QI, Chunyuan, 510641 Singapore (SG); CHEN, Xingxing, 510746 Singapore (SG); MA, Zhuona, 510746 Singapore (SG); LIU, Hui, 529781 Singapore (SG)
(74) Representative: Isarpatent

(57) **Abstract**

A metasurface structure includes a substrate having a first region and a second region not overlapping with the first region; a first pillar element within the first region on the substrate; and a second pillar element within the second region on the substrate. The first pillar element has a first sectional profile and the second pillar element has a second sectional profile that is different from the first sectional profile. At least one of the first sectional profile and the second sectional profile is of a non-rectangular shape.

## Description

### Field of the Invention

The invention relates to the field of semiconductor technology, in particular to a metasurface structure and a manufacturing method thereof.

### Description of the Prior Art

A metasurface is a layer of sub-wavelength-scale nanostructures that can be used to design functional devices in ultrathin form. Various metasurface-based optical devices - coined as flat optics devices - have been realized with distinction performances in research laboratories using electron beam lithography.

To make such devices mass producible at low cost, metasurfaces over a large area have also been defined with lithography steppers and scanners, which are commonly used in semiconductor foundries.

### Summary of the Invention

It is one object of the present invention to provide an improved metasurface structure and its manufacturing method to solve the deficiencies or shortcomings of the prior art.

One aspect of the invention provides a metasurface structure including a substrate having a first region and a second region not overlapping with the first region; a plurality of first pillar elements formed within the first region on the substrate; and a plurality of second pillar elements formed within the second region on the substrate, wherein the plurality of first pillar elements has a first sectional profile and the plurality of second pillar elements has a second sectional profile that is different from the first sectional profile, and wherein at least one of the first sectional profile and the second sectional profile is of a non-rectangular shape.

According to some embodiments, the plurality of first pillar elements and the plurality of second pillar elements comprise amorphous silicon.

According to some embodiments, the plurality of first pillar elements and the plurality of second pillar elements are surrounded by an encapsulation material.

According to some embodiments, the encapsulation material comprises silicon oxide.

According to some embodiments, the substrate comprises silicon.

According to some embodiments, the metasurface structure further comprises a dielectric layer on the substrate, wherein the plurality of first pillar elements and the plurality of second pillar elements are disposed on the dielectric layer.

According to some embodiments, the dielectric layer comprises silicon oxide.

According to some embodiments, the first sectional profile comprises a trapezoidal shape, an inverted trapezoidal shape, or a parallelogram shape.

According to some embodiments, the second sectional profile comprises a trapezoidal shape, an inverted trapezoidal shape, or a parallelogram shape.

According to some embodiments, the plurality of first pillar elements and the plurality of second pillar elements have substantially the same height.

Another aspect of the invention provides a method for forming a metasurface structure. A substrate is provided. The substrate includes a first region and a second region not overlapping with the first region. A plurality of first pillar elements is formed within the first region on the substrate. A plurality of second pillar elements is formed within the second region on the substrate. The plurality of first pillar elements has a first sectional profile and the plurality of second pillar elements has a second sectional profile that is different from the first sectional profile. At least one of the first sectional profile and the second sectional profile is of a non-rectangular shape.

According to some embodiments, the plurality of first pillar elements and the plurality of second pillar elements comprise amorphous silicon.

According to some embodiments, the plurality of first pillar elements and the plurality of second pillar elements are surrounded by an encapsulation material.

According to some embodiments, the encapsulation material comprises silicon oxide.

According to some embodiments, the method further comprises the step of forming a dielectric layer on the substrate, wherein the plurality of first pillar elements and the plurality of second pillar elements are disposed on the dielectric layer.

According to some embodiments, the dielectric layer comprises silicon oxide.

According to some embodiments, the first sectional profile comprises a trapezoidal shape, an inverted trapezoidal shape, or a parallelogram shape.

According to some embodiments, the second sectional profile comprises a trapezoidal shape, an inverted trapezoidal shape, or a parallelogram shape.

According to some embodiments, the plurality of first pillar elements and the plurality of second pillar elements have substantially the same height.

Still another aspect of the invention provides a method of forming a metasurface structure. A substrate is provided. The substrate includes a first region and a second region not overlapping the first region. An amorphous silicon layer is formed on the substrate in the first region and the second region. A hard mask layer is formed on the amorphous silicon layer. A first photoresist layer is coated on the hard mask layer. A photolithography process is performed on the first photoresist layer in the first region with a first exposure condition, and a photolithography process is performed on the first photoresist layer in the second region with a second exposure condition different from the first exposure condition, thereby forming photoresist patterns with different profiles in the first region and the second region. Using the photoresist patterns with different profiles as an etching hard mask, the amorphous silicon layer is subjected to a first etching process, thereby forming pillar elements with different profiles. A second photoresist layer is then coated on the pillar elements in the first region. The second photoresist layer is used as an etching hard mask and a second etching process is performed on the pillar elements in the second region, thereby forming a plurality of first pillar element in the first regions on the substrate and a plurality of second pillar elements in the second region on the substrate. The plurality of first pillar elements comprises a first cross-sectional profile and the plurality of second pillar elements comprises a second cross-sectional profile different from the first cross-sectional profile. At least one of the first cross-sectional profile and the second cross-sectional profile is non-rectangular.

These and other objectives of the present invention will no doubt become obvious to those of ordinary skill in the art after reading the following detailed description of the preferred embodiment that is illustrated in the various figures and drawings.

### Brief Description of the Drawings

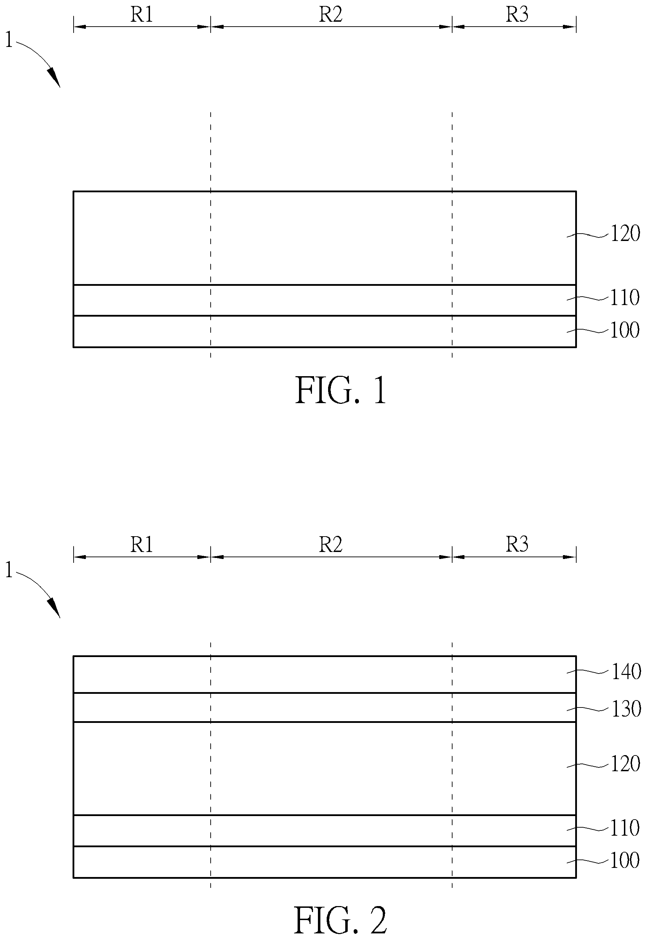

FIG. 1 to FIG. 7 are schematic cross-sectional views of a method for forming a metasurface structure according to an embodiment of the present invention.

### Detailed Description

In the following detailed description of the disclosure, reference is made to the accompanying drawings, which form a part hereof, and in which is shown, by way of illustration, specific embodiments in which the invention may be practiced. These embodiments are described in sufficient detail to enable those skilled in the art to practice the invention.

Other embodiments may be utilized, and structural, logical, and electrical changes may be made without departing from the scope of the present invention. Therefore, the following detailed description is not to be considered as limiting.

Please refer to FIG. 1 to FIG. 7, which are schematic cross-sectional views of a method for forming a metasurface structure according to an embodiment of the present invention. First, as shown in FIG. 1, a substrate 100 is provided, which has a first region R1, a second region R2 and a third region R3. According to an embodiment of the present invention, the first region R1, the second region R2 and the third region R3 do not overlap each other. According to an embodiment of the present invention, the substrate 100 may be a semiconductor substrate, for example, the substrate 100 may include silicon. According to an embodiment of the present invention, the substrate 100 may be a silicon substrate, but is not limited thereto.

According to an embodiment of the invention, a dielectric layer 110 is formed on the substrate 100. According to an embodiment of the present invention, for example, the dielectric layer 110 may include silicon oxide, but is not limited thereto. According to an embodiment of the present invention, an amorphous silicon layer 120 is formed on the dielectric layer 110.

As shown in FIG. 2, a hard mask layer 130 is then formed on the amorphous silicon layer 120. The hard mask layer 130 may be a silicon nitride layer, but not limited to. According to an embodiment of the present invention, a photoresist layer 140 is then coated on the hard mask layer 130.

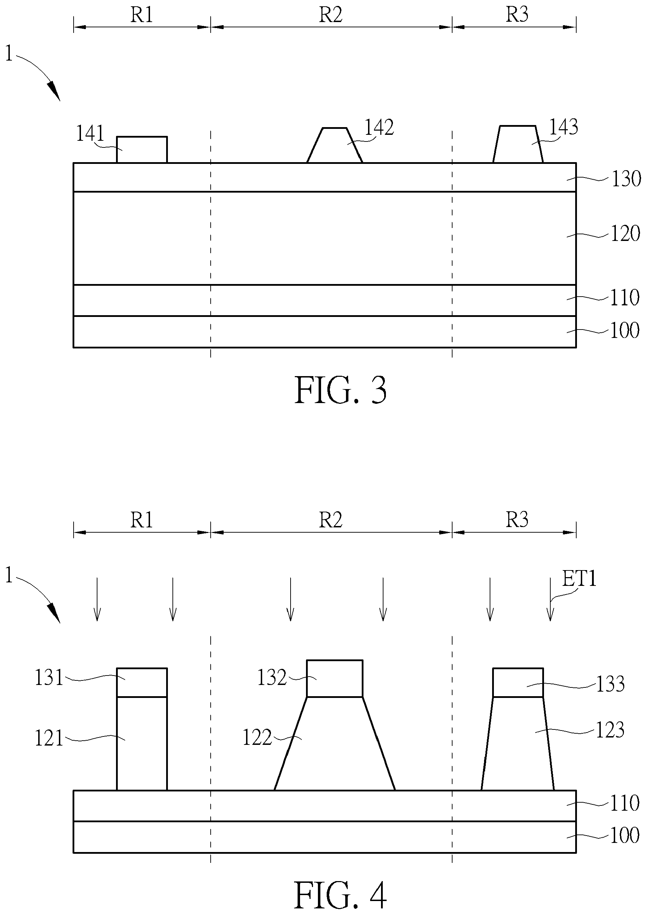

As shown in FIG. 3, a photolithography process is then performed, by using different exposure conditions in the first region R1, the second region R2 and the third region R3, and using different optical proximity correction (OPC) patterns in the corresponding regions on the photomask. The photoresist patterns 141, 142 and 143 with different sectional profiles can be formed on the hard mask layer 130 in the first region R1, the second region R2 and the third region R3, respectively. OPC technology is to use calculation methods to correct the patterns on the photomask so that the patterns projected on the photoresist meet the design requirements as much as possible, which is known as a lithography resolution enhancement technology.

According to an embodiment of the present invention, for example, a first OPC pattern is used in the photomask region relative to the first region R1, and a second OPC pattern different from the first OPC pattern is used in the photomask regions relative to the second region R2 and the third region R3. The first OPC pattern is, for example, an octagon, and the second OPC pattern is, for example, a thirty-six sided polygon, but not limited thereto. The first exposure condition, for example, a relatively shorter exposure focal length is adopted in the first region R1 and the third region R3, and the second exposure condition, for example, a relatively longer exposure focal length different from the first exposure condition is adopted in the second region R2, so that photoresist patterns 141, 142 and 143 with different sectional profiles are respectively formed on the hard mask layer 130 in the first region R1 , the second region R2 and the third region R3 .

As shown in FIG. 4, a first etching process ET1, such as an anisotropic dry etching process, is then performed to etch the hard mask layer 130 not covered by the photoresist patterns 141, 142 and 143, thereby transferring the photoresist patterns 141, 142, and 143 to the hard mask layer 130, respectively, and forming the hard mask patterns 131, 132, and 133 in the first region R1, the second region R2, and the third region R3, respectively. The anisotropic dry etching process ET1 is continued to etch the amorphous silicon layer 120 not covered by the hard mask patterns 131, 132, 133, respectively in the first region R1, the second region R2 and the third region R3, thereby forming pillar elements 121, 122, 123 with different sectional profiles. For the sake of simplicity, only one pillar element 121, only one pillar element 122, and only one pillar element 123 are shown in the first region R1, the second region R2 and the third region R3, respectively. It should be understood that each of the first region R1, the second region R2 and the third region R3 may have multiple pillar elements.

According to an embodiment of the present invention, for example, the pillar element 121 in the first region R1 may have a rectangular profile, and the pillar elements 122, 123 in the second regions R2 and the third region R3 may have non-rectangular profiles, for example, trapezoidal profiles, inverted trapezoidal profile or parallelogram profile. According to an embodiment of the invention, for example, the pillar elements 121, 122, 123 may have different sectional profiles from each other.

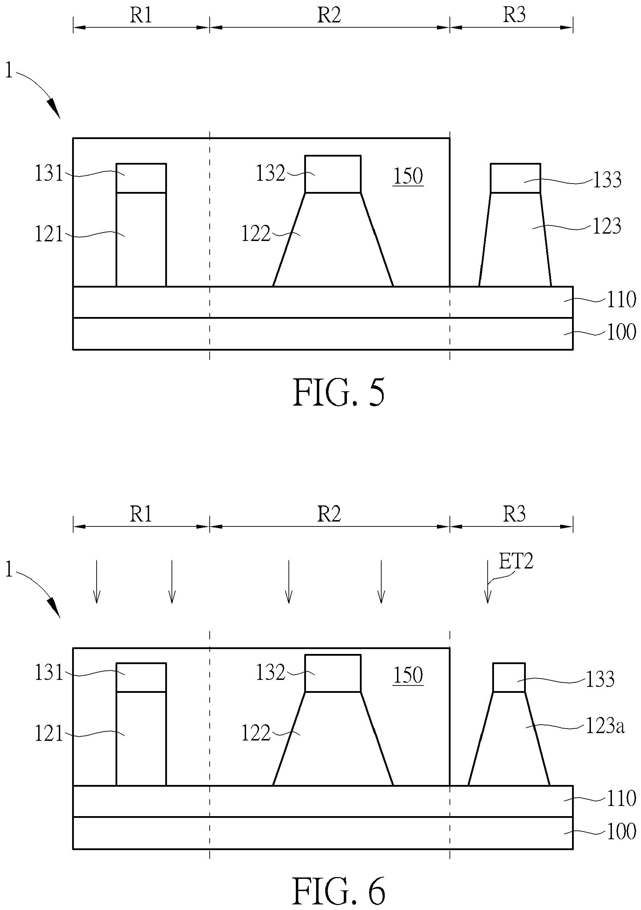

As shown in FIG. 5, a photolithography process is performed to form a photoresist pattern 150 on the first region R1 and the second region R2. According to an embodiment of the present invention, for example, the photoresist pattern 150 covers the pillar elements 121 and 122 in the first region R1 and the second region R2, but exposes the pillar elements 123 in the third region R3.

As shown in FIG. 6, a second etching process ET2 , such as an anisotropic dry etching process, is then performed to etch the pillar elements 123 not covered by the photoresist pattern 150 to form trimmed pillar elements 123a. According to embodiments of the invention, for example, the trimmed post element 123a may have a non-rectangular profile, such as a trapezoidal profile, an inverted trapezoidal profile, or a parallelogram profile. According to an embodiment of the invention, for example, the pillar elements 121, 122, 123a may have different sectional profiles from each other. According to an embodiment of the present invention, for example, the etching power of the anisotropic dry etching process ET2 is greater than that of the anisotropic dry etching process ET1, and the etching time of the anisotropic dry etching process ET2 is longer than that of the anisotropic dry etching process ET1.

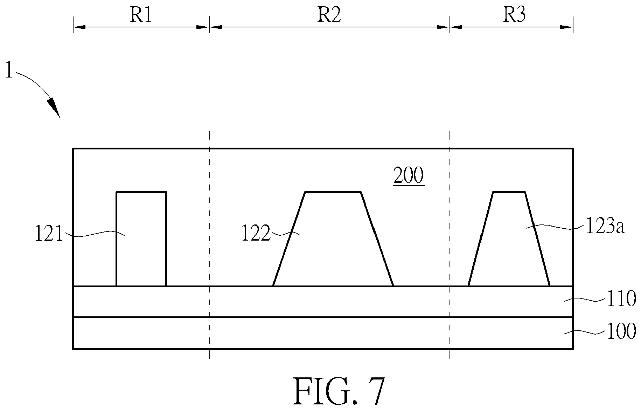

As shown in FIG. 7, the photoresist pattern 150 is removed, and then the hard mask patterns 131, 132, 133 can be optionally removed, and then the encapsulation material 200 is formed, such that the metasurface structure 1 is completed. According to an embodiment of the invention, the pillar elements 121, 122, 123a are surrounded by an encapsulation material 200. According to an embodiment of the present invention, the encapsulation material 200 may include silicon oxide, but is not limited thereto. According to an embodiment of the present invention, the pillar elements 121, 122, 123a have substantially the same height, and the pillar elements 121, 122, 123a may have different sectional profiles from each other.

Those skilled in the art will readily observe that numerous modifications and alterations of the device and method may be made while retaining the teachings of the invention.

## Claims

1. A metasurface structure (1), comprising:
a substrate (100) having a first region (R1) and a second region (R2) not overlapping with the first region (R1);
a plurality of first pillar elements (121) formed within the first region (R1) on the substrate (100); and
a plurality of second pillar elements (122, 123) formed within the second region (R2) on the substrate (100), wherein the plurality of first pillar elements (121) has a first sectional profile and the plurality of second pillar elements (122, 123) has a second sectional profile that is different from the first sectional profile (121), and wherein at least one of the first sectional profile and the second sectional profile is of a non-rectangular shape.

2. The metasurface structure (1) according to claim 1, wherein the plurality of first pillar elements (121) and the plurality of second pillar elements (122, 123) comprise amorphous silicon or wherein the substrate (100) comprises silicon.

3. The metasurface structure (1) according to claim 1 or 2, wherein the plurality of first pillar elements (121) and the plurality of second pillar elements (122, 123) are surrounded by an encapsulation material (200).

4. The metasurface structure (1) according to claim 3, wherein the encapsulation material (200) comprises silicon oxide.

5. The metasurface structure (1) according to claim 1 further comprising: a dielectric layer (110) on the substrate (100), wherein the plurality of first pillar elements (121) and the plurality of second pillar elements (122, 123) are disposed on the dielectric layer (110).

6. The metasurface structure (1) according to claim 5, wherein the dielectric layer (110) comprises silicon oxide.

7. The metasurface structure (1) according to one of the claims 1 to 6, wherein the first sectional profile comprises a trapezoidal shape, an inverted trapezoidal shape, or a parallelogram shape, and/or wherein the second sectional profile comprises a trapezoidal shape, an inverted trapezoidal shape, or a parallelogram shape, and/or wherein the plurality of first pillar elements (121) and the plurality of second pillar elements (122, 123) have substantially the same height.

8. A method for forming a metasurface structure (1), comprising:
providing a substrate (100) having a first region (R1) and a second region (R2) not overlapping with the first region (R1);
forming a plurality of first pillar elements (121) within the first region (R1) on the substrate (100); and
forming a plurality of second pillar elements (122, 123) within the second region (R2) on the substrate (100), wherein the plurality of first pillar elements (121) has a first sectional profile and the plurality of second pillar elements (123, 123) has a second sectional profile that is different from the first sectional profile, and wherein at least one of the first sectional profile and the second sectional profile is of a non-rectangular shape.

9. The method according to claim 8, wherein the plurality of first pillar elements (121) and the plurality of second pillar elements (122, 123) comprise amorphous silicon.

10. The method according to claim 8 or 9, wherein the plurality of first pillar elements (121) and the plurality of second pillar elements (122, 123) are surrounded by an encapsulation material (200).

11. The method according to claim 10, wherein the encapsulation material (200) comprises silicon oxide.

12. The method according to any of the claims 8 to 11 further comprising:
forming a dielectric layer (110) on the substrate (100), wherein the plurality of first pillar elements (121) and the plurality of second pillar elements (122, 123) are disposed on the dielectric layer (110).

13. The method according to claim 12, wherein the dielectric layer (110) comprises silicon oxide.

14. The method according to any of the claims 8 to 13, wherein the first sectional profile comprises a trapezoidal shape, an inverted trapezoidal shape, or a parallelogram shape, and/or wherein the second sectional profile comprises a trapezoidal shape, an inverted trapezoidal shape, or a parallelogram shape, and/or wherein the plurality of first pillar elements and the plurality of second pillar elements have substantially the same height.

15. A method of forming a metasurface structure (1) comprising:
providing a substrate (100) having a first region (R1) and a second region (R2) not overlapping the first region (R1);
forming an amorphous silicon layer (120) on the substrate (100) in the first region (R1) and the second region (R2);
forming a hard mask layer (130) on the amorphous silicon layer (120);
coating a first photoresist layer (140) on the hard mask layer (130);
performing a photolithography process on the first photoresist layer (140) in the first region (R1) with a first exposure condition, and performing a photolithography process on the first photoresist layer (140) in the second region (R2) with a second exposure condition different from the first exposure condition, thereby forming photoresist patterns (141, 142) with different profiles in the first region (R1) and the second region (R2);
using the photoresist patterns (141, 142) with different profiles as an etching hard mask, subjecting the amorphous silicon layer to a first etching process, thereby forming pillar elements with different profiles;
coating a second photoresist layer on the pillar elements in the first region (R1); and
using the second photoresist layer to perform a second etching process to the pillar elements in the second region (R2), thereby forming a plurality of first pillar element (121) in the first region (R1) on the substrate (100) and a plurality of second pillar elements (122, 123) in the second region (R2) on the substrate (100), wherein the plurality of first pillar elements (121) comprises a first cross-sectional profile and the plurality of second pillar elements (122, 123) comprises a second cross-sectional profile different from the first cross-sectional profile, wherein at least one of the first cross-sectional profile and the second cross-sectional profile is non-rectangular.

## Amended claims

### Amended claims in accordance with Rule 137(2) EPC.

1. A metasurface structure (1), comprising:
a substrate (100) having a first region (R1), a second region (R2) and a third region (R3) not overlapping each other;
a plurality of first pillar elements (121) formed within the first region (R1) on the substrate (100);
a plurality of second pillar elements (122) formed within the second region (R2) on the substrate (100),
a plurality of third pillar elements (123a) formed within the third region (R3) on the substrate (100), wherein the plurality of first pillar elements (121) has a first sectional profile, the plurality of second pillar elements (122) has a second sectional profile, the plurality of third pillar elements (123a) has a third sectional profile, wherein the first sectional profile, the second sectional profile and the third sectional profile are of different polygonal shapes.

2. The metasurface structure (1) according to claim 1, wherein the plurality of first pillar elements (121), the plurality of second pillar elements (122) and the plurality of third pillar elements (123a) comprise amorphous silicon or wherein the substrate (100) comprises silicon.

3. The metasurface structure (1) according to claim 1 or 2, wherein the plurality of first pillar elements (121), the plurality of second pillar elements (122) and the plurality of third pillar elements (123a) are surrounded by an encapsulation material (200).

4. The metasurface structure (1) according to claim 3, wherein the encapsulation material (200) comprises silicon oxide.

5. The metasurface structure (1) according to claim 1 further comprising:
a dielectric layer (110) on the substrate (100), wherein the plurality of first pillar elements (121), the plurality of second pillar elements (122) and the plurality of third pillar elements (123a) are disposed on the dielectric layer (110).

6. The metasurface structure (1) according to claim 5, wherein the dielectric layer (110) comprises silicon oxide.

7. The metasurface structure (1) according to one of the claims 1 to 6, wherein the plurality of first pillar elements (121), the plurality of second pillar elements (122) and the plurality of third pillar elements (123a) have substantially the same height.

8. A method for forming a metasurface structure (1), comprising:
providing a substrate (100) having a first region (R1), a second region (R2) and a third region (R3) not overlapping each other;
forming a plurality of first pillar elements (121) within the first region (R1) on the substrate (100);
forming a plurality of second pillar elements (122) within the second region (R2) on the substrate (100), forming a plurality of third pillar elements (123a) within the third region (R3) on the substrate (100), wherein the plurality of first pillar elements (121) has a first sectional profile, the plurality of second pillar elements (122) has a second sectional profile and the plurality of third pillar elements (123a) has a third sectional profile wherein the first sectional profile, and the second sectional profile and the third sectional profile are of different polygonal shapes.

9. The method according to claim 8, wherein the plurality of first pillar elements (121), the plurality of second pillar elements (122) and the plurality of third pillar elements (123a) comprise amorphous silicon.

10. The method according to claim 8 or 9, wherein the plurality of first pillar elements (121), the plurality of second pillar elements (122) and the plurality of third pillar elements (123a) are surrounded by an encapsulation material (200).

11. The method according to claim 10, wherein the encapsulation material (200) comprises silicon oxide.

12. The method according to any of the claims 8 to 11 further comprising:
forming a dielectric layer (110) on the substrate (100), wherein the plurality of first pillar elements (121), the plurality of second pillar elements (122) and the plurality of third pillar elements (123a) are disposed on the dielectric layer (110).

13. The method according to claim 12, wherein the dielectric layer (110) comprises silicon oxide.

14. The method according to any of the claims 8 to 13, wherein the plurality of first pillar elements (121), the plurality of second pillar elements (122), and the plurality of third pillar elements (123a) have substantially the same height.

15. A method of forming a metasurface structure (1) comprising:
providing a substrate (100) having a first region (R1) and a second region (R2) not overlapping the first region (R1);
forming an amorphous silicon layer (120) on the substrate (100) in the first region (R1) and the second region (R2);
forming a hard mask layer (130) on the amorphous silicon layer (120);
coating a first photoresist layer (140) on the hard mask layer (130);
performing a photolithography process on the first photoresist layer (140) in the first region (R1) with a first exposure condition, and performing a photolithography process on the first photoresist layer (140) in the second region (R2) with a second exposure condition different from the first exposure condition, thereby forming photoresist patterns (141, 142) with different profiles in the first region (R1) and the second region (R2);
using the photoresist patterns (141, 142) with different profiles as an etching hard mask, subjecting the amorphous silicon layer to a first etching process, thereby forming pillar elements with different profiles;
coating a second photoresist layer on the pillar elements in the first region (R1); and
using the second photoresist layer to perform a second etching process to the pillar elements in the second region (R2), thereby forming a plurality of first pillar element (121) in the first region (R1) on the substrate (100) and a plurality of second pillar elements (122, 123) in the second region (R2) on the substrate (100), wherein the plurality of first pillar elements (121) comprises a first cross-sectional profile and the plurality of second pillar elements (122, 123) comprises a second cross-sectional profile different from the first cross-sectional profile, wherein at least one of the first cross-sectional profile and the second cross-sectional profile is non-rectangular.
